# EUROPEAN PATENT APPLICATION

(11) **EP 4 617 066 A1**
(43) Date of publication of application: **17.09.2025**
(21) Application number: 24163944.2
(22) Date of filing: 15.03.2024
(51) Int. Cl.: B41J 2/14, C23C 14/04

(54) **DEVICE FOR AND METHOD OF DEPOSITING A PRINTING MATERIAL ON A SUBSTRATE**

(71) Applicant: Nederlandse Organisatie voor toegepast-natuurwetenschappelijk Onderzoek TNO, 2595 DA 's-Gravenhage (NL)
(72) Inventor: VAN DEN BRAND, Jeroen, 2595 DA's-Gravenhage (NL); ARUTINOV, Gari, 2595 DA's-Gravenhage (NL); HENDRIKS, Rob Jacob, 2595 DA's-Gravenhage (NL)
(74) Representative: V.O.

(57) **Abstract**

The invention is directed at a device for depositing a printing material comprising an optically transmissive plate comprising a first and second surface. The first surface provides an optical reception surface. The second surface comprises deposition cavities for holding printing material prior to deposition. An optical source provides optical radiation to the first surface. The plate is rotatably suspended. The optical source is in a first area adjacent and opposite the first surface, offset from an axis of rotation of the plate. The device comprises a filling arrangement in a second area adjacent the second surface of the plate, also offset from the rotation axis and different from the first area. This enables periodic filling of cavities during rotation of the plate. The cavities are through holes extending from the first to the second surface. Also a deposition method is disclosed.

## Description

### Field of the invention

The present invention is directed at a device for depositing a printing material on a substrate, the device comprising an optically transmissive plate comprising a first surface and a second surface opposite the first surface, wherein the first surface provides an optical reception surface for receiving an optical radiation signal, and wherein the second surface comprises one or more deposition cavities configured for holding said printing material prior to deposition thereof, wherein the first surface is configured for cooperating with an optical source for receiving said optical radiation signal. The invention is further directed at a method of depositing a printing material on a substrate.

### Background

Although the present document includes references to various other documents, no admission is made that any reference constitutes prior art. The discussion of references refers to their content as presented therein, and does not acknowledge nor confirm the accuracy or pertinency thereof. It will be understood that, although a number of prior art publications are referred to herein, this reference does not constitute an admission that any of these documents form part of the common general knowledge in the art in any country.

Continuous high-throughput deposition of fine dots of various materials, such as fine types of solder paste, or conductive or non-conductive glues, is not possible with commercial printing technologies. Such commercial printing technologies for example include stencil printing, dispensing, and jetting. Instead of applying mainstream printing technologies, alternative solutions are therefore available to enable the printing of such fine dots of material. For example, various known laser-based processes, such as deposition techniques referred to as laser induced forward transfer (LIFT), are capable of depositing fine deposits of interconnects and other materials.

Laser induced forward transfer applies an optical source, such as a laser, to print small fractions of material from a thin donor layer onto a receiving substrate. To do so, an optically transmissive plate (printing plate) comprises a surface provided with printing or deposition cavities. These cavities, for deposition, hold a printing material which is to be deposited on the substrate that is located underneath the optically transmissive plate. The opposite side or back side of the optically transmissive printing plate is selectively illuminated by an optical signal, e.g. a laser pulse. LIFT is based on the principle that the illuminated printing material in the cavity will heat-up and be propelled, as a result of gas production due to evaporation, from the cavity.

A disadvantage of these latter technologies, however, is that they are typically either batch-based and require replenishing of material per a donor plate/cassette, or they are provided as a roll-to-roll (R2R) configuration and suffer from a poor material usage efficiency while additionally requiring renewal of a feeding donor foil. These disadvantages limit industrialization of these technologies. Another challenge that is often encountered in similar technologies is the complexity of homogenization of heat flux to printing cavities from which the printing material is deposited. A homogeneous heat flux is desired in order to obtain a controlled outflow of printing material, but this is typically hampered by the shape of the cavities.

### Summary of the invention

It is an object of the present invention to overcome the abovementioned shortcomings of the prior art, and to provide a device for depositing a printing material on a substrate that is suitable to scale, allows for a continuous process and is suitable to be industrialized.

To this end, there is provided herewith a device for depositing a printing material on a substrate. The device comprises an optically transmissive plate, which includes a first surface and a second surface opposite the first surface. The first surface provides an optical reception surface for receiving an optical radiation signal. The second surface comprises one or more deposition cavities. The deposition cavities are configured for holding the printing material prior to deposition thereof. The first surface is configured for cooperating with an optical source for receiving the optical radiation signal. The optically transmissive plate is a rotatably suspended in the device. This enables rotation of the optically transmissive plate within the plane of the optically transmissive plate. The optical source is located in a first area adjacent and opposite the first surface of the optically transmissive plate. This first area is offset from a (notional or actual) axis of rotation. The offset enables periodic illumination of the deposition cavities while they move past the optical source in the first area, i.e. during rotation of the optically transmissive plate. Furthermore, the device comprises a filling arrangement which is located in a second area adjacent the second surface of the optically transmissive plate. The second area is different from the first area and the second area is also offset from the (notional or actual) axis of rotation. This enables periodic filling of the cavities with the printing material while they move past the filling arrangement in the second area, during rotation of the optically transmissive plate. In particular, the one or more cavities are through holes extending from the first surface to the second surface.

The present invention combines the use of a rotating optically transmissive plate with cavities provided by through holes, with a filling arrangement for filling the cavities and an optical source for illuminating the cavities in order to perform the deposition. The filling arrangement is located in a different area than the optical source. Therefore, while rotating the optically transmissive plate the cavities subsequently pass the first area, the second area, the first area, the second area .... and so further. Therefore, the cavities are periodically illuminated in the first area in order to deposit the printing material, after which the cavities are refilled again in the second area. The depositing of printing material may therefore be performed as an ongoing and continuous process.

The filling may be performed very efficiently, for example by using a squeegee, a roller, or other material supplier that is configured for supplying the printing material at a (slightly) elevated pressure. Due to the cavities being through-holes, this may be done accurately and quickly in absence of any air or gas pockets or bubbles remaining in the cavities. Any air or other gas present in the cavities, may escape during filling because of the cavities being through-holes. The cavities are filed via the second surface while the remaining air may escape via the backside of the through-holes on the first surfaces. As a whole, the repetitive filling and depositing thus forms an efficient process.

The application of cavities provided by through-holes has another important advantage. The through-holes are not closed at the first surface, and hence do not include a top cover. Therefore, any heat that is directly absorbed through the interface between the printing material and the ambient surroundings at the first surface (i.e. not via the walls of the cavity) is immediately dissipated again and does not contribute to the release of the printing material during deposition. The heat flux is thereby homogenized to a large extend, resulting in a very controlled deposition of the printing material from the cavities onto the substrate surface. In comparison, this is not achievable if the cavities would have top surfaces, as is the case in many in conventional technologies. Here the top surfaces are typically oriented differently with respect to the side walls, which created an unbalance in the heat flux that is to be dealt with by added homogenization (e.g. by adding additional layers, modifying layer thicknesses, diffusion of optical energy, etc.). This added homogenization adds to the complexity of conventional printing methods, which is effectively avoided in the solution of the present invention.

In respect of the above, it is to be realized that in accordance with different embodiments of the above concept, the rotational suspension of the optically transmissive plate may be realized in different manners. The rotational plate may be suspended by means of an axis, i.e. a physical axis, whereas an actuator may act on the axis or the edges or first or second surface of the plate in order to enable rotation thereof. Alternatively, the rotational plate may also be suspended at it's edges, without an actual physical axis being present. The actuators may act on the edges (e.g. for a circular plate) or engage using a wheel acting on the first or second surface, for example. The application of a physical axis is therefore not essential to the construction, and may be dispensed with. In that case, the absence of the axis advantageously provides room for other parts, such as to yield a compact design. In those embodiments without a physical axis, in the present documents definitions or explanations on the relative location of certain aspects of the present idea may still refer to their locations in relation to an axis, in which case a notional axis is meant (i.e. a notional axis of a rotational motion).

In some embodiments, the through holes forming the one or more cavities comprise outflow openings at the second surface of the optically transmissive plate. The outflow openings may be shaped in any desired manner, for example a circular shaped outflow opening may be preferred, but is not essential. The outflow opening may likewise be oval, polygonal or arbitrarily shaped. Furthermore, in other or further embodiments, the through holes forming the one or more cavities comprise openings at the first surface of the optically transmissive plate. The openings at the first surface of the optically transmissive plate provide for the absence of a top surface or closure of the cavity on the side opposite the outflow openings. As explained above, this provides for any heat that is directly absorbed through the interface between the printing material and the ambient surroundings at the first surface (i.e. not via the walls of the cavity) to be immediately dissipated again without contributing to the release of the printing material during deposition. The heat flux is thereby homogenized to a large extend, resulting in a very controlled deposition of the printing material from the cavities onto the substrate surface.

In some embodiments, at least one of the deposition cavities comprises a wall forming an interface between the through hole and the transmissive plate, wherein the wall is an oblique sidewall extending between the first surface and the second surface of the optically transmissive plate, wherein the oblique sidewall extends such that an internal angle between the second surface and the oblique sidewall is larger than 90 degrees, preferably between 100 and 150 degrees, more preferably between 110 and 135 degrees. The wall forming the interface between the through hole and the transmissive plate may also be referred to as a sidewall of the cavity. The sidewalls of the cavity spatially define the interior of the through hole. Preferably, these sidewalls are oblique such that the surface of the walls obliquely face the outflow openings of the cavities at the second surface of the transmissive plate. This somewhat tilted arrangement of the sidewalls cause the printing material to be propelled out of the second surface upon being illuminated. Illumination of cavities causes heat to be transferred through the sidewalls to the printing material in the cavity, which upon building up sufficient pressure is propelled out of the cavity. Due to the sidewalls being tilted (slanted, oblique) with their surface slightly facing the outflow opening in the second surface, the printing material is propelled in the direction of the outflow opening in the second surface, towards the substrate onto which it is to be deposited. The cavity may be of any desired spatial shape, but preferably the sidewalls are tilted under a fixed internal angle with the second surface such as to yield a cavity having the spatial shape of a truncated cone. Optical energy being received transverse to the first surface, will then impinge on the sidewalls under a fixed angle. This homogenizes the heat transfer to the sidewalls as much as possible.

In other or further embodiments, the optically transmissive plate comprises an optical absorption layer for converting optical energy from the optical radiation signal into a heat amount. This absorption layer will optimize the transfer of heat to the cavities, from the optically transmissive plate. In some of these embodiments, at least one of the deposition cavities comprises a wall forming an interface between the through hole and the transmissive plate (e.g. one or more of the sidewalls), wherein the wall comprises a multilayer release stack comprising a thermal absorption layer, wherein the thermal homogenization layer is located between the optical absorption layer and the through hole, wherein the thermal absorption layer comprises one or more thermal barrier layers having a thermal conductivity that is smaller than a further thermal conductivity of the optical absorption layer, such as to enable lateral heat transfer within the optical absorption layer for homogeneously distributing and conveying the heat amount across the wall to the printing material in the at least one deposition cavity prior to deposition thereof. In these embodiments, the absorption layer may for example be made of a highly thermally conductive metal, and is responsible to receive incident energy from a pulsed laser. These pulses could be relatively long in duration, for example a pulse duration of one to several nanoseconds. Such pulses are relatively easy to produce and may provide desired transfer characteristics. Alternatively, also other pulse lengths may be used, for example shorter pulse durations may likewise be suitable. Such shorter pulses may be in the order of picoseconds or even hundreds of femtoseconds. In addition to the optical absorption layer, a thermal absorption layer (also referred to as diffusing layer) having lower thermal conductivity than the optical absorption layer may be applied. This thermal absorption layer, which could be a single thermal barrier layer of suitable thermal conductivity or a stack of multiple thermal barrier layers, is operative to redistribute hot spots around the cavity. This ensures uniform heat profile around the whole cavity (i.e. all surrounding cavity walls).

In some embodiments, the filling arrangement comprises a supply element for supplying the printing material, and wherein the filling arrangement further comprises a squeegee for distributing the printing material across the second surface or the first surface for enabling said filling of the one or more deposition cavities with the printing material. Although other configurations may likewise be suitable for providing the filling arrangement, for example a roller in combination with a feeding unit or supply element for feeding the printing material to the roller, the use of a squeegee with a supply element provides for an efficient implementation having a compact form factor that is well suitable to distribute the printing material into the cavities for filling the cavities.

In some embodiments, the optical source is a collimated light source providing a beam of said optical radiation signal. The advantages of using a collimated optical source are to be found in the fact that the alignment of the optical signal results in a uniform distribution of optical radiation that is received on the receiving surface of the optical absorption layer, i.e. at the interface between the optically transmissive material of the optically transmissive plate and the optical absorption layer. As may be appreciated, if the optical radiation is collimated, differences in the amount of radiation received per surface area of the receiving surface of the optical absorption layer only exist if parts of the receiving surface have a distinguishing orientation (e.g. deviating from other parts of the receiving surface). Such parts of the surface may exist - as will be discussed later - dependent on the design of the deposition cavities. However, if in accordance with some of the above described embodiments, the sidewalls are all oblique at a fixed internal angle such as to provide cavities having the spatial shape of truncated cones, the sidewalls - when illuminated from above through the first surface - receive an equal amount of radiation per surface area everywhere around the cavity, thereby receiving a homogeneous heat flux.

In yet some of these embodiments, the device further comprises a beam splitting element cooperating with the optical source in order to split the beam of said optical radiation signal into a plurality of beams, for simultaneously illuminating the optically transmissive plate in a plurality of locations in the first area. In these embodiment, a plurality of cavities may be illuminated simultaneously in order to release the printing material therefrom for deposition.

In other or further embodiments, the device further comprises a substrate carrier for supporting the substrate onto which the printing material is to be deposited, the substrate carrier being located adjacent and opposite the second surface and at least underneath the first area, wherein the first area is located above the first surface and the substrate carrier being located below the second surface of the optically transmissive plate, wherein the device further comprises an actuator for rotating the optically transmissive plate. The above provides for a compact arrangement of parts for providing a device in accordance with embodiments falling under the scope of the claims.

In some embodiments, the substrate carrier comprises a conveyor mechanism, such as a conveyor belt, for moving the substrate relative to the optically transmissive plate. A conveyor mechanism as described enables to convey multiple substrates in a sequence, for example in an industrial setting. For example, if the device of the present invention would be applied in order to deposit solder pockets for soldering very small electronic components on a printed circuit board or similar substrate, the conveyor mechanism may provide a plurality of these substrates subsequently in an ongoing industrial process. In connection therewith, yet in further advantageous embodiments, the device further comprises a controller, wherein the controller is configured for coordinating the rotation of the optically transmissive plate with the moving the substrate by the conveyor mechanism, and further with the timing of the periodic illumination of the one or more deposition cavities, for depositing the printing material on the substrate at a desired location.

In accordance with a second aspect of the present invention, there is provided a method of depositing a printing material on a substrate using a deposition device comprising an optically transmissive plate having a first surface and a second surface opposite the first surface, the first surface providing an optical reception surface for receiving an optical radiation signal from an optical source, and the second surface comprising one or more deposition cavities configured for holding the printing material prior to deposition thereof, the deposition device further comprising the optical source for providing the optical radiation signal; the method comprising: rotating the optically transmissive plate within the plane of the optically transmissive plate; illuminating the optically transmissive plate with the optical radiation signal, using an optical source located in a first area adjacent and opposite the first surface, the first area being offset from an axis of rotation of the optically transmissive plate, thereby periodically illuminating the one or more deposition cavities while the deposition cavities move past the optical source in the first area during said rotating of the optically transmissive plate; and filling, using a filling arrangement in a second area adjacent one of the second surface or the first surface of the optically transmissive plate, the one or more deposition cavities with the printing material while the deposition cavities move past the filling arrangement in the second area during said rotating of the optically transmissive plate, wherein the second area is different from the first area and the second area is offset from the axis of rotation; wherein the one or more cavities of the deposition device are provided by through holes extending from the first surface to the second surface of the optically transmissive plate and wherein the filling is performed by filling of the through holes. For example, in some embodiments, the second area is located adjacent the second surface, such that the filling of the deposition cavities is performed via the second surface.

The method as described may be applied in an industrial process for depositing printing material on a plurality of substrates, wherein the substrates are conveyed such as to move underneath the second surface of the optically transmissive plate and underneath the first area, and wherein optically transmissive plate is illuminated with the optical radiation signal, such as to at least periodically deposit the printing material, wherein the moving of the substrates, the rotation of the optically transmissive plate and the illumination by the optical source are coordinated using a controller for depositing the printing material in target locations on the substrates.

### Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figure 1 schematically illustrates a cross-section of a device for depositing a printing material on a substrate, in accordance with an embodiment of the invention;
Figure 2 schematically illustrates a top-view of a device for depositing a printing material on a substrate, in accordance with an embodiment of the invention;
Figure 3 schematically illustrates a top-view of a device in accordance with another embodiment of the invention;
Figure 4A-C schematically illustrate the depositing of a printing material from a cavity, in accordance with an embodiment of the invention;
Figure 5 schematically illustrates the depositing of a printing material from a plurality of cavities in an embodiment of the invention.

### Detailed description

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

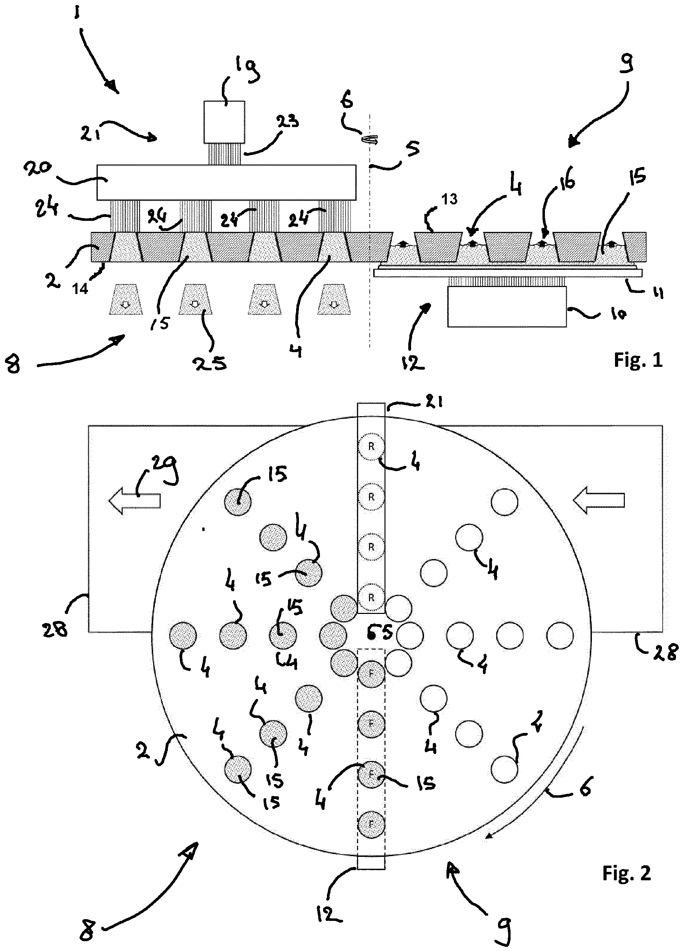

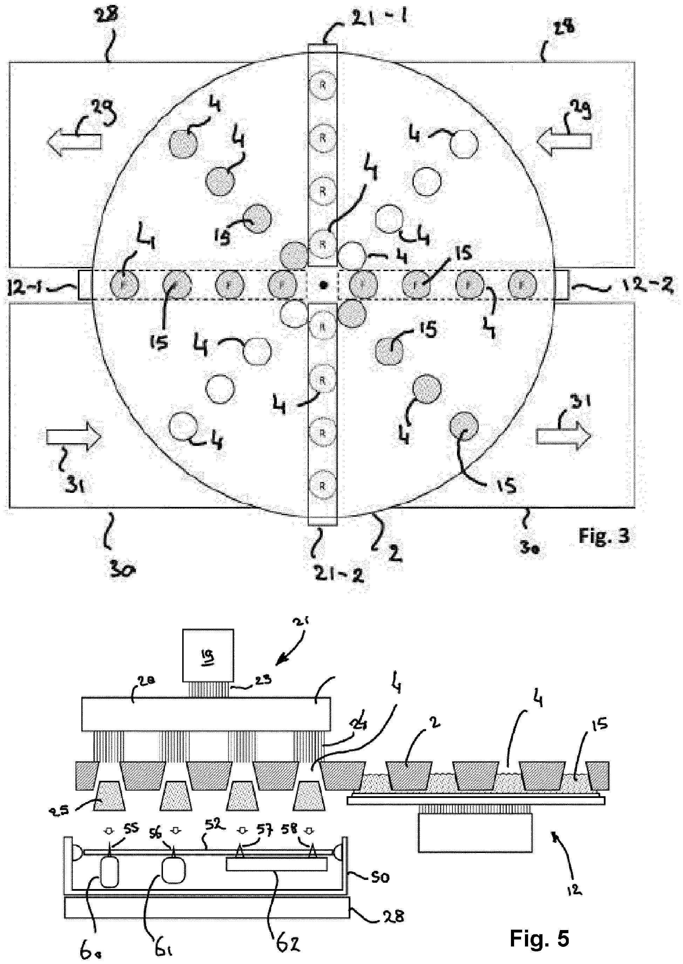

Figure 1 schematically illustrates a cross-section of a device 1 for depositing a printing material 15 on a substrate, in accordance with an embodiment of the invention. The device 1 is suitable for depositing a printing material 15 on a substrate 52 (figure 5). In fact, the device 1 enables to deposit portions 25 of printing material 15 on the surface of the substrate 52. The substrate 52 may be a printed circuit board (PCB), a sheet of material, an object or semi-manufactured object, or a surface to be adhered by e.g. gluing to another part. The printing material 15 is deposited by the formation of pockets or droplets 25 that are propelled from deposition cavities 4 that are filled with the printing material 15 prior to release thereof. The device 1 is suitable for and may be used to perform laser induced forward transfer (LIFT) of the printing material 15.

The device 1 comprises an optically transmissive plate 2. The optically transmissive plate 2 may be made of an optically transmissive material, such as quartz or another type of transmissive crystal or mineral, a type of glass, a transmissive polymer, a transmissive resin or any other transmissive material providing suitable optical and thermodynamic properties. In terms of the latter, the material of which the optically transmissive plate 2 is made preferably transmits an optical radiation signal 24, with which it may be illuminated, effectively in order to convey the majority thereof and prevent the formation of heat in the optically transmissive plate 2 itself as much as possible. The optically transmissive plate 2 comprises a first surface 13 and a second surface 14 opposite the first surface 13. The first surface 13 provides an optical reception surface for receiving an optical radiation signal 24 from an optical source 21. In the present embodiment illustrated in figure 1, the optical source 21 comprises a laser unit 19 providing a beam 23 that is operatively coupled with a beam splitter 20 (schematically illustrated as a box) providing four beams 24. Each of the four beams 24 may be independently controlled to switch it on or off, and to selectively provide the optical radiation as a pulse with a predetermined pulse duration. The pulse duration may range from 100 femtoseconds to several or tens of nanoseconds.

The optically transmissive plate 2 comprises a plurality of deposition cavities 4. The deposition cavities 4 are configured for holding the printing material 15 prior to deposition. Preferably, the plurality of deposition cavities 4 is located in a regular arrangement on the optically transmissive plate 2. The printing or deposition of printing material 15 may then be performed by selectively illuminating the cavities 4, for example by operating each of the beams 24 under the control of a controller (not shown) or control system (not shown). The optically transmissive plate 2 is suspended such as to be rotatable around an axis of rotation 5.

The first surface 3 is configured for cooperating with the optical source 11 for receiving the optical radiation signal 10. In accordance with the invention, the optically transmissive plate 2 is a rotatably suspended in the device 1 for enabling rotation of the optically transmissive plate 2 within the plane of the optically transmissive plate 2. The axis of rotation 5 as well as a possible rotation direction 6 are indicated in figure 1. It is to be understood that the optically transmissive plate 2 may likewise rotate in counter direction to the direction that is indicated in figure 1, without the device 1 working substantially different. The optical source 21 is located in a first area adjacent and opposite the first surface 13 of the optically transmissive plate 2. For example, in the embodiment illustrated in figure 1, the location of the optical source 21 in the first area is directly above the first surface 13, and as illustrated in figure 2 in an area above conveyor 28. The first area, indicated by the outline of optical source 21 in figure 2, is offset from the rotation axis 5. By rotation of the optically transmissive plate 2, the cavities 4 periodically move underneath the optical source 21 and can be illuminated by operating beams 24. By doing so, the printing material 15 in cavities 4 heats up and is deposited, forming the pockets or droplets 25.

Furthermore, the device 1 in figure 1 comprises a filling arrangement 12, comprising an material supplier unit 10 and a squeegee 11. The squeegee 11 causes the printing material 15 to be delivered to cavities 4. This is schematically illustrated by arrows 16 in figure 1. The filling arrangement 12 is present opposite the second surface 14, i.e. underneath optically transmissive plate 2 in figure 1. Figure 2 illustrates in top-view, that the filling arrangement 12 is likewise arranged slightly offset from rotation axis 5.

In operation, with reference to figures 1 and 2, while rotating the optically transmissive plate 2 the filling arrangement 12 fills the cavities 4 (indicated with an 'F'), which thereafter following their path of rotation move towards and underneath optical source 21. Optical source 21 is controlled to be operated such that each cavity 4 underneath the beam splitter 20 is illuminated by receiving a pulse of optical radiation (indicated with an 'R') from one of the beams 24. This will release the printing material 15 from the cavities 4. The droplets or pockets 25 are illustrated with dotted lines to indicate that these will be subsequently formed as a result of the beams 24 illuminating each of the cavities 4, which in the situation illustrated in figure 1 still contain the printing material 15. The optically transmissive plate 2 may be roughly divided into a part 8 subsequent to the filling arrangement 12 (in rotation of the plate 2) and prior to the optical source 21, and a part 9 prior to the filling arrangement 12 (in rotation of the plate 2) and subsequent to the optical source 21.

Figure 2 further illustrates that the cavities 4 are arranged in in groups of four (or more) cavities. This is not essential to the invention and the skilled person will appreciate that when each of the beams 24 can be controlled individually, the cavities 4 may be arranged differently on the optically transmissive plate 2, i.e. not in groups per sé. The advantage of the groups illustrated in figures 1 and 2 is that all cavities 4 in the group may be illuminated at once, hence only requiring the beams 24 of the beam splitter 20 as a whole can be operated simultaneously. Figure 2 also illustrates the conveyor 28, which allows to move substrates 52 underneath the deposition area where the optical source 21 is located. Preferably, motion of the conveyor 28, operation of the optical source 21 and rotation of the optically transmissive plate 2 are controlled by a controller (not shown) such as to coordinate deposition of droplets 25 in order to deposit the droplets 25 in the exact location on the substrate 52 where they are desired.

As follows from figure 1, the cavities 4 are through-holes extending from the first surface 13 to the second surface 14. The invention combines the use of a rotating optically transmissive plate 2 with cavities 4 formed by through holes, with a filling arrangement 12 for filling the cavities 4 and an optical source 21 for illuminating the cavities 4 in order to perform the deposition. The filling arrangement 12 is located in a different area than the optical source 21. Therefore, while rotating the optically transmissive plate 2 the cavities 4 subsequently pass the first area (underneath optical source 21), the second area (underneath filling arrangement 12), the first area (underneath optical source 21), the second area (underneath filling arrangement 12) .... and so further. Therefore, the cavities 4 are periodically illuminated in the first area (underneath optical source 21) in order to deposit the printing material 15, after which the cavities 4 are refilled again in the second area (underneath filling arrangement 12). The depositing of printing material 15 may therefore be performed as an ongoing and continuous process.

The filling can be performed efficiently using the squeegee 11. As an alternative to using a squeegee 11, it is also possible to apply a roller or other material supplier that is configured for supplying the printing material 15 at a (slightly) elevated pressure. The elevated pressure ensures that the printing material 25 is pressed into the cavities 4, as illustrated by the arrows 16. Due to the cavities 4 being through-holes, this may be done accurately and quickly in absence of any air or gas pockets or bubbles remaining in the cavities 4. Any air or other gas present in the cavities, may escape during filling because of the cavities 4 are open at the first surface 13, i.e. at their top sides. The cavities 4 are filled via the second surface 14 while the remaining air may escape via the backside of the through-holes 4 on the first surface 13. As a whole, the repetitive filling and depositing thus forms an efficient process.

The application of cavities 4 provided by through-holes has another important advantage. The through-holes are not closed at the first surface 13 and hence do not include a top cover. Therefore, any heat that is directly absorbed through the interface between the printing material 15 and the ambient surroundings at the first surface 13 (i.e. not via the walls of the cavity 4) is immediately dissipated again and does not contribute to the release of the printing material 15 during deposition. The heat flux is thereby homogenized to a large extend, resulting in a very controlled deposition of the printing material 15 from the cavities 4 onto the substrate surface.

In respect of the above, it is to be realized that the rotational suspension of the optically transmissive plate 2 may be realized in different manners. The rotational plate may be suspended by means of an axis, i.e. a physical axis (e.g. present at the location of axis 5 in figure 1), whereas an actuator may act on the axis or the edges or first 13 or second surface 14 of the plate 2 in order to enable rotation thereof. Alternatively, the rotational optically transmissive plate 2 may also be suspended at it's edges, without an actual physical axis being present. The actuators may act on the edges (e.g. for a circular plate) or engage using a wheel acting on the first 13 or second surface 14, for example. The application of a physical axis is therefore not essential to the construction, and may be dispensed with. In that case, the absence of the axis advantageously provides room for other parts, such as to yield a compact design.

Upon illuminating each cavity 4, the printing material 15 will be released therefrom forming a droplet 25, and deposited as a printed portion on the surface of the substrate 52 (see figure 5). To this end, the optical radiation signal 24 may be provided by the optical source 21 as a continuous signal which is temporarily blocked, e.g. by an optical obstruction such as a shutter or similar. The optical obstruction could be moved away for illuminating a cavity 4 selectively. Alternatively, the optical source 21 may be triggered selectively to fire the optical radiation signal 24 as an optical pulse. The pulse may contain sufficient optical energy (desirably distributed in time) to trigger the deposition of the printing material 15 from the cavity 4. As a further alternative, the optical radiation signal 24 provided by the optical source 21 may be a pulsed laser beam (from laser unit 19 providing laser beam 23 to the beam splitter 20) formed of a (continuous or discontinuous) pulse train, where the pulses may be selectively blocked or transmitted. This may for example be achieved by using an optical obstruction, such as a controllable shutter, or by switching the laser unit 19 of optical source 21 on and off selectively.

Figure 3 illustrates an alternative embodiment of the device 1 in accordance with an embodiment of the invention. In this embodiment, the device 1 comprises two conveyors 28 and 30 moving in different directions (indicated by arrows 29 and 31). The rotating optically transmissive plate 2, which rotates in clockwise direction in the figure, comprises a first optical source 21-1 and a second optical source 21-2. Furthermore, in between the conveyors 28 and 30, also two filler arrangements 12-1 and 12-2 are present. The embodiment illustrated in figure 3 works in the same way as the embodiment of figure 2, but can obtain twice the yield as a result of the two optical sources 21-1 and 21-2 and two filler arrangements 12-1 and 12-2 being present.

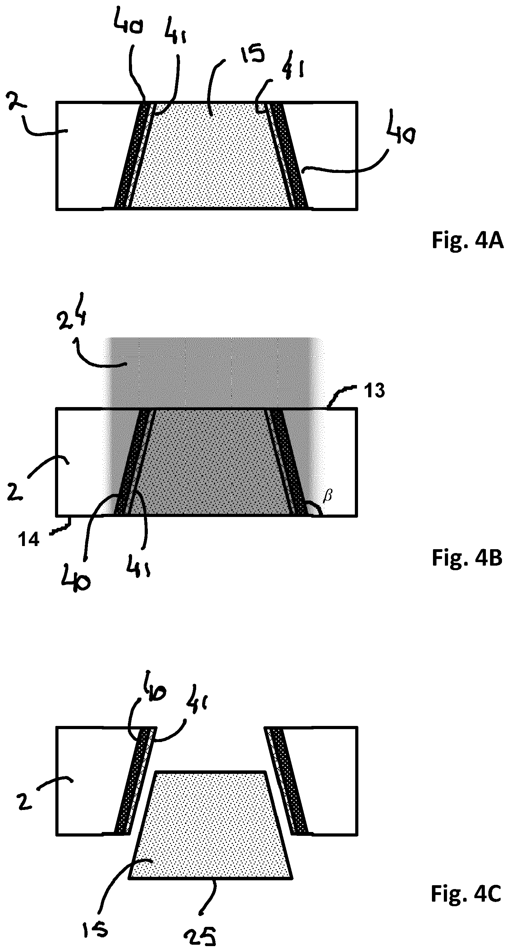

Figures 4A to 4C illustrate a cavity 4 in cross-section, and the process of deposition of the printing material 15 upon illumination with the optical pulse from beam 24. As can be seen in figure 4A, the cavity comprises an optical absorption layer 40 on the side walls thereof. The optical absorption layer 40 is configured for absorbing the optical radiation from an optical pulse, and for converting this radiation energy into heat. This optical absorption layer 40 will optimize the transfer of heat from the optically transmissive plate 2 to the cavity 4. Optionally, but preferably, the optical absorption layer 40 is covered by thermal homogenization layer or thermal absorption layer 41 (sometimes referred to also as 'diffusion layer'). The thermal absorption layer 41 may comprise one or more (for example several) thermal barrier layers. The thermal barrier layers have a thermal conductivity that is smaller than a thermal conductivity of the optical absorption layer 40. This enables lateral heat transfer within the optical absorption layer for homogeneously distributing and conveying the heat amount across the wall to the printing material 15 in the cavity 4 prior to deposition thereof. In these embodiments, the optical absorption layer 40 may for example be made of a highly thermally conductive metal, and is responsible to receive incident energy from a pulsed laser.

Figure 4B shows the step of illuminating the cavity with a pulse of the optical beam 24. In the preferred embodiments, the laser unit 19 of optical source 21 is a collimated light source providing a beam 23 of optical radiation. The advantages thereof is that the alignment of the optical signal, i.e. the flat wave front, results in a uniform distribution of optical radiation received on the receiving surface of the optical absorption layer 40, i.e. at the interface between the optically transmissive material of the optically transmissive plate 2 and the optical absorption layer 40. If the optical radiation is collimated, any differences in the amount of radiation received per surface area of the receiving surface of the optical absorption layer 40 only exist if parts of the receiving surface have a distinguishing orientation (e.g. deviating from other parts of the receiving surface). Such parts of the surface may exist dependent on the design of the deposition cavities 4. For example, this would be the case is the walls of cavity 4 in figures 4A to 4C would be curved, or would include a fold to a second part being of different orientation. In accordance the embodiment illustrated in figure 4A to 4C, the sidewalls are all oblique at a fixed internal angle *β* (see figure 4B) between the second surface 14 and the side wall. The internal angle *β* between the second surface 14 and the oblique sidewall is larger than 90 degrees, preferably between 100 and 150 degrees, more preferably between 110 and 135 degrees. This provides cavities 4 having the spatial shape of truncated cones. The sidewalls, when illuminated from above through the first surface 13, receive an equal amount of radiation per surface area everywhere around the cavity, and thereby receive a homogeneous heat flux. Figure 4C illustrate the resulting release of printing material 15 forming a droplet 25.

In figure 5, the cross-section also illustrated in figure 1 is shown, but including the conveyor 28 and a substrate 52. The substrate 52 in the example is a printed circuit board (PCB) comprising components 60, 61 and 62. The PCB is held by holder unit 50 for supporting the substrate 52 on the conveyor belt. The skilled person will appreciate that figure 5 is a schematic figure, and that the holder unit 50 is merely exemplary and in reality, dependent on the type of substrate 52, may not even be present. Figure 5, in fact, schematically illustrates the depositing of printing material 15 in the form of droplets 25, from cavities 4 in an embodiment of the invention. The figure is merely illustrative of one way of applying the invention, and should by no means be considered to be limiting on the scope of the claims.

The present invention has been described in terms of some specific embodiments thereof. It will be appreciated that the embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Expressions such as "consisting of', when used in this description or the appended claims, should be construed not as an exhaustive enumeration but rather in an inclusive sense of "at least consisting of'. Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Any of the claimed or disclosed devices or portions thereof may be combined together or separated into further portions unless specifically stated otherwise, without departing from the claimed invention. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

## Claims

1. Device for depositing a printing material on a substrate, the device comprising:
an optically transmissive plate comprising a first surface and a second surface opposite the first surface, wherein the first surface provides an optical reception surface for receiving an optical radiation signal, and wherein the second surface comprises one or more deposition cavities configured for holding said printing material prior to deposition thereof, wherein the first surface is configured for cooperating with an optical source for receiving said optical radiation signal;
wherein the optically transmissive plate is a rotatably suspended in the device for enabling rotation of the optically transmissive plate within the plane of the optically transmissive plate;
wherein the optical source is located in a first area adjacent and opposite the first surface of the optically transmissive plate, the first area being offset from an axis of rotation, for enabling periodic illumination of the one or more deposition cavities while moving past the optical source in the first area during rotation of the optically transmissive plate; and
wherein the device further comprises a filling arrangement, wherein the filling arrangement is located in a second area adjacent the second surface of the optically transmissive plate, the second area being different from the first area and the second area being offset from the axis of rotation, for enabling periodic filling of the one or more cavities with the printing material while moving past the filling arrangement in the second area during rotation of the optically transmissive plate;
wherein the one or more cavities are through holes extending from the first surface to the second surface.

2. Device according to claim 1, wherein the through holes forming the one or more cavities comprise outflow openings at the second surface of the optically transmissive plate.

3. Device according to claim 2, wherein the through holes forming the one or more cavities comprise openings at the first surface of the optically transmissive plate.

4. Device according to any one or more of the preceding claims, wherein at least one of the deposition cavities comprises a wall forming an interface between the through hole and the transmissive plate, wherein the wall is an oblique sidewall extending between the first surface and the second surface of the optically transmissive plate, wherein the oblique sidewall extends such that an internal angle between the second surface and the oblique sidewall is larger than 90 degrees, preferably between 100 and 150 degrees, more preferably between 110 and 135 degrees.

5. Device according to any one or more of the preceding claims, wherein the optically transmissive plate comprises an optical absorption layer for converting optical energy from the optical radiation signal into a heat amount.

6. Device according to claim 5, wherein at least one of the deposition cavities comprises a wall forming an interface between the through hole and the transmissive plate, wherein the wall comprises a multilayer release stack comprising a thermal absorption layer, wherein the thermal homogenization layer is located between the optical absorption layer and the through hole, wherein the thermal absorption layer comprises one or more thermal barrier layers having a thermal conductivity that is smaller than a further thermal conductivity of the optical absorption layer, such as to enable lateral heat transfer within the optical absorption layer for homogeneously distributing and conveying the heat amount across the wall to the printing material in the at least one deposition cavity prior to deposition thereof.

7. Device according to any one or more of the preceding claims, wherein the filling arrangement comprises a supply element for supplying the printing material, and wherein the filling arrangement further comprises a squeegee for distributing the printing material across the second surface or the first surface for enabling said filling of the one or more deposition cavities with the printing material.

8. Device according to any one or more of the preceding claims, wherein the optical source is a collimated light source providing a beam of said optical radiation signal.

9. Device according to claim 8, further comprising a beam splitting element cooperating with the optical source in order to split the beam of said optical radiation signal into a plurality of beams, for simultaneously illuminating the optically transmissive plate in a plurality of locations in the first area.

10. Device according to any one or more of the preceding claims, wherein the device further comprises a substrate carrier for supporting the substrate onto which the printing material is to be deposited, the substrate carrier being located adjacent and opposite the second surface and at least underneath the first area, wherein the first area is located above the first surface and the substrate carrier being located below the second surface of the optically transmissive plate, wherein the device further comprises an actuator for rotating the optically transmissive plate.

11. Device according to claim 10, wherein the substrate carrier comprises a conveyor mechanism, such as a conveyor belt, for moving the substrate relative to the optically transmissive plate.

12. Device according to claims 10 and 11, further comprising a controller, wherein the controller is configured for coordinating the rotation of the optically transmissive plate with the moving the substrate by the conveyor mechanism, and further with the timing of the periodic illumination of the one or more deposition cavities, for depositing the printing material on the substrate at a desired location.

13. Method of depositing a printing material on a substrate using a deposition device comprising an optically transmissive plate having a first surface and a second surface opposite the first surface, the first surface providing an optical reception surface for receiving an optical radiation signal from an optical source, and the second surface comprising one or more deposition cavities configured for holding the printing material prior to deposition thereof, the deposition device further comprising the optical source for providing the optical radiation signal; the method comprising:
rotating the optically transmissive plate within the plane of the optically transmissive plate;
illuminating the optically transmissive plate with the optical radiation signal, using an optical source located in a first area adjacent and opposite the first surface, the first area being offset from an axis of rotation of the optically transmissive plate, thereby periodically illuminating the one or more deposition cavities while the deposition cavities move past the optical source in the first area during said rotating of the optically transmissive plate; and
filling, using a filling arrangement in a second area adjacent one of the second surface or the first surface of the optically transmissive plate, the one or more deposition cavities with the printing material while the deposition cavities move past the filling arrangement in the second area during said rotating of the optically transmissive plate, wherein the second area is different from the first area and the second area is offset from the axis of rotation;
wherein the one or more cavities of the deposition device are provided by through holes extending from the first surface to the second surface of the optically transmissive plate and wherein the filling is performed by filling of the through holes.

14. Method according to claim 13, wherein the second area is located adjacent the second surface, such that the filling of the deposition cavities is performed via the second surface.

15. Method according to any one or more of claims 13-14, wherein the method is applied in an industrial process for depositing printing material on a plurality of substrates, wherein the substrates are conveyed such as to move underneath the second surface of the optically transmissive plate and underneath the first area, and wherein optically transmissive plate is illuminated with the optical radiation signal, such as to at least periodically deposit the printing material, wherein the moving of the substrates, the rotation of the optically transmissive plate and the illumination by the optical source are coordinated using a controller for depositing the printing material in target locations on the substrates.
